# EUROPÄISCHE PATENTSCHRIFT

(11) **EP 3 227 911 B1**
(45) Veröffentlichungstag und Bekanntmachung des Hinweises auf die Patenterteilung: **18.11.2020**
(21) Anmeldenummer: 15831129.0
(22) Anmeldetag: 03.12.2015
(51) Int. Cl.: H01L 21/677, H01L 21/02, B08B 3/04, B08B 3/12

(54) **VORRICHTUNG ZUR BEHANDLUNG VON SUBSTRATEN**
APPARATUS FOR PROCESSING SUBSTRATES
APPAREIL POUR LE TRAITEMENT DE SUSTRATS

(30) Priorität: 05.12.2014 DE 102014118039
(43) Veröffentlichungstag der Anmeldung: 11.10.2017
(73) Patentinhaber: RENA Technologies GmbH, 78148 Gütenbach (DE)
(72) Erfinder: HANSEN, Stefan-Heinrich, 79183 Waldkirch (DE); UIHLEIN, Markus, 79110 Freiburg (DE); SANDER, Bernd-Uwe, 79111 Freiburg (DE); PEDIADITAKIS, Stephan Alexis, 79194 Heuweiler (DE)
(74) Vertreter: Heyerhoff Geiger & Partner Patentanwälte PartGmbB
(86) Internationale Anmeldenummer: PCT/DE2015/100517
(87) Internationale Veröffentlichungsnummer: WO 2016/086924

(56) Entgegenhaltungen:
- WO-A1-2005/048336
- JP-A- 2001 341 827
- US-A- 5 601 655

## Beschreibung

Die Erfindung betrifft eine Vorrichtung gemäß dem Oberbegriff des Anspruchs 1 und ein Verfahren gemäß dem Anspruch 13.

In vielen Bereichen, insbesondere in der Halbleiter- oder genauer der Solarzellenindustrie, sind für verschiedene Anwendungen Behandlungen von Substraten, insbesondere von Wafern, notwendig, welche nur eine Seite des Substrats betreffen. Bei solchen Einseitenprozessen soll die der zu behandelnden Seite gegenüberliegende Seite des Substrats üblicherweise von der Behandlung nicht betroffen sein. Im Bereich der Nassprozesse sind hierbei beispielsweise die nasschemische Kantenisolation (einseitiges Abätzen des per Diffusion rückseitig aufgebrachten parasitären Emitters), Politur (chemische Glättung der texturierten Substratvorder- beziehungsweise Substratrückseite), galvanische Prozesse, wie elektrochemische Abscheidung einer Metallisierung, oder einseitige Vorkonditionierungsschritte vor anderen Behandlungen, wie beispielsweise einer Hydrophobierung der Substratkanten, zu nennen.

Im Gegensatz zu Batch-Verfahren, welche systembedingt beide Seiten des Substrats betreffen, sind in Inlineverfahren einseitige Behandlungen auf verschiedene Weise realisierbar. Bei einem hierfür aus EP 1 733 418 B1 bekannten Verfahren wird ein unterseitiger Vollkontakt des Substrats mit einer Behandlungsflüssigkeit unter Ausbildung eines sogenannten Meniskus hergestellt. Bei einem anderen bekannten Verfahren wird ein einseitiger Kontakt des Substrats mit der Behandlungsflüssigkeit über strukturierte Rollen, welche die Behandlungsflüssigkeit an die Substratunterseite herantransportieren, hergestellt.

Vorstehend und nachfolgend wird auf Substrate Bezug genommen. Hierunter fallen auch Halbleitersubstrate, insbesondere Wafer wie Siliziumwafer. Unter Solarzellenwafern sind Wafer zu verstehen, welche für die Herstellung von Solarzellen bestimmt sind.

Für die Behandlung von Substraten mit einer Flüssigkeit, insbesondere für nasschemische Inline-Einseitenprozesse, bietet das vorgenannte Verfahren zur Herstellung eines unterseitigen Vollkontakts zwischen Substrat und Behandlungsflüssigkeit unter Ausbildung eines Meniskus eine Reihe von Vorteilen. Neben einer gleichmäßigen Behandlung der Substratunterseite und des vollflächigen thermischen Kontakts des Substrats zur Oberfläche der Behandlungsflüssigkeit, was üblicherweise in einer verbesserten Prozesskontrolle resultiert, ist durch den permanenten Kontakt des Substrats die Verwendung von Behandlungsflüssigkeiten mit einer geringeren Konzentration möglich, als dies beim unterseitigen Aufrollen der Behandlungsflüssigkeit der Fall ist (gleiche Prozessstrecke, aber längere Prozesszeit). Neben geringeren Chemiekosten reduziert dies auch einen eventuellen Gasphasenangriff auf der Substratoberseite. Auch ist im Vergleich der apparative Aufwand deutlich geringer.

Das Prinzip des unterseitigen Vollkontakts des Substrats unter Ausbildung eines Meniskus kann jedoch auch Nachteile mit sich bringen. Ein möglicher Nachteil ist, dass bei einem Abriss des Meniskus - ein solcher findet üblicherweise beim Verlassen eines die Behandlungsflüssigkeit enthaltenden Behälters oberhalb eines Ausgangswehres statt - bedingt durch die Oberflächenspannung der Behandlungsflüssigkeit zwischen dem Substrat und der Badoberfläche eine Flüssigkeitslamelle aufgespannt wird, die beim Weitertransport des Substrats reißt. Hierbei zeigt die Hauptdehnungsrichtung der Lamelle üblicherweise in Fahrtrichtung des Substrats, welche auch als dessen Transportrichtung bezeichnet werden kann. Bei einem solchen Abriss werden häufig Tropfen der Behandlungsflüssigkeit auf die Oberseite des Substrats geschleudert. Die Stärke dieses unerwünschten Effektes hängt von der Oberflächenspannung der Behandlungsflüssigkeit, ihrer Viskosität sowie der Prozessführung (Verhältnis Becken- beziehungsweise Behälterfüllstand zu Wehrhöhe und/oder des daraus resultierenden Rezirkulationsflows) ab.

Um den aus derartigen Spritzern erwachsenden Problemen entgegenzutreten, kann erwogen werden, die Eigenschaften der Flüssigkeit zu verändern, beispielsweise durch Zusetzen von die Viskosität ändernden Materialien. Dies ist jedoch nicht immer möglich oder erwünscht oder mit anderen Problemen verbunden. Auch kann die Oberseite des Substrats mit einer oder mehreren Schutzschichten vor dem Einwirken dieser Spritzer geschützt werden. Hiermit ist jedoch häufig ein erheblicher Verfahrensmehraufwand verbunden oder diese Vorgehensweise ist nicht oder schlecht mit der sonstigen Prozessführung vereinbar.

Die Druckschriften WO 2005/048336 A1 und JP 2001 341827 A offenbaren jeweils eine Vorrichtung zur Behandlung von Substraten mit einer Flüssigkeit, welche eine Transportvorrichtung zum Transportieren des Substrats entlang einer Transportrichtung sowie mindestens ein schräg zur Transportrichtung angeordnetes Luftmesser zum Herunterblasen von auf dem Substrat befindlicher Flüssigkeit umfasst.

Ferner ist in der Druckschrift US 5 601 655 A ein Verfahren zum Reinigen eines Substrats offenbart, bei dem das Substrat entlang einer Transportrichtung transportiert wird, wobei eine zu reinigende Oberfläche des Substrats nach unten zeigt und die zu reinigende Oberfläche von unten mit einem schräg zur Transportrichtung ausgerichteten Strom einer Reinigungsflüssigkeit beaufschlagt wird.

Vor diesem Hintergrund liegt der vorliegenden Erfindung die Aufgabe zugrunde, eine Vorrichtung zur Verfügung zu stellen, welche es ermöglicht, Spritzer der beschriebenen Art auf die Oberseite des Substrats zu reduzieren.

Diese Aufgabe wird gelöst durch eine Vorrichtung mit den Merkmalen des Anspruchs 1.

Ferner liegt der Erfindung die Aufgabe zu Grunde, ein Verfahren zur Verfügung zu stellen, mittels welchem bei einem Ablösen einer Flüssigkeitslamelle von einer Substratkante die Bildung von Spritzern verringert werden kann.

Diese Aufgabe wird gelöst durch ein Verfahren mit den Merkmalen des Verfahrensanspruchs 13.

Vorteilhafte Weiterbildungen sind jeweils Gegenstand abhängiger Unteransprüche.

Die erfindungsgemäße Vorrichtung zur Behandlung von Substraten mit einer Flüssigkeit weist eine Transportvorrichtung, mittels welcher die Substrate in einer Transportrichtung durch einen die Flüssigkeit enthaltenden Behälter transportierbar sind, und ein Wehr mit einer von den Substraten überfahrbaren Kante, welche zumindest abschnittsweise schräg zu der Transportrichtung der Substrate verläuft, auf.

Der Erfindung liegt die Überlegung zugrunde, dass die voranstehend beschriebenen Spritzer vor allem dann auftreten, wenn die von den Substraten überfahrbare Kante des Wehrs orthogonal zur Transportrichtung der Substrate verläuft. Denn in diesem Fall ist die mechanische Kraft auf die bei einem Weitertransport der Substrate zwischen Flüssigkeit und Substrathinterkante ausgebildete Flüssigkeitslamelle am höchsten. Wird die Beanspruchungsgrenze der Flüssigkeitslamelle überschritten, beginnt diese an einer geometrisch undefinierten Stelle zu reißen und Spritzer können auf die Oberseite des Substrats oder die Oberseite nachfolgender Substrate geschleudert werden.

Wird hingegen die von den Substraten überfahrbare Kante des Wehrs zumindest abschnittsweise schräg zu der Transportrichtung der Substrate ausgebildet, ist die im Laufe der Weiterbewegung des Substrats auftretende Belastung der Flüssigkeitslamelle an derjenigen Ecke der Substrathinterkante, welche zuerst die Kante überfährt, am größten, sodass ein Rückzug der Flüssigkeitslamelle an dieser Ecke beginnt. Infolgedessen bildet sich eine Rückzugsfront der Flüssigkeitslamelle aus. Wird das Substrat in der Transportrichtung weitertransportiert, so läuft diese Rückzugsfront zu einer gegenüberliegenden Ecke der Substrathinterkante. Auf diese Weise kann die Krafteinwirkung auf die Flüssigkeitslamelle vermindert werden. Die Flüssigkeitslamelle wird weniger stark vorgespannt. Durch die von einer Ecke der Substrathinterkante zu der anderen Ecke laufenden Rückzugsfront, welche gleichzeitig eine Abrissfront darstellt, wird ein "sanftes" Abreißen initiiert. Infolgedessen können Spritzer auf die nicht zu behandelnde Oberseite des Substrats oder eines nachfolgenden Substrats vermieden oder zumindest reduziert werden.

Der vorbeschriebene Effekt lässt sich auch über eine schräge Ausrichtung der Substrate zu der überfahrbaren Kante des Wehrs erreichen oder durch ein verdrehtes Auflegen der Substrate auf die Transportvorrichtung. Aus mehreren Gründen ist dies in der Praxis jedoch nachteilig:
Zum einen ist ein solch verdrehtes Auflegen der Substrate nicht mit allen gängigen Handlingsystemen möglich. Vielmehr sind gängige Handlingsysteme dazu vorbereitet, die Substrate mit einer Substratseite parallel zur Transportrichtung auf die Transportvorrichtung aufzulegen. Diejenigen Systeme, die ein verdrehtes Auflegen prinzipiell erlauben, müssten in aufwendiger Weise hierfür eingerichtet, insbesondere angelernt, werden.

Zum anderen können solche verdreht aufgelegten Substrate nur schwierig und nicht mit einfachen Mitteln auf einer Transportspur zentriert werden. Bei einer manuellen Verdrehung der Substrate auf der Transportvorrichtung ist eine reproduzierbar verdrehte Positionierung ohne Hilfsmittel nur schwer erreichbar. Im Übrigen hat die Praxis gezeigt, dass ein verdrehtes Auflegen der Substrate mit einem erhöhten Bruch und folglich mit erhöhten Kosten einhergehen kann.

Nicht zuletzt erhöht sich durch das verdrehte Auflegen der Substrate die effektive Länge und Breite der Substrate und damit die erforderliche Durchfahrtsbreite und Durchfahrtslänge, was die Vorrichtung bei gleichem Durchsatz verteuert.

Aufgrund dieser Nachteile werden die Substrate vorteilhafterweise mittels der Transportvorrichtung derart transportiert, dass zwei Kanten des Substrats parallel zur Transportrichtung verlaufen, wobei jedoch das Wehr die erfindungsgemäß ausgestaltete Kante aufweist, welche zumindest abschnittweise schräg zu der Transportrichtung der Substrate verläuft.

In einer vorteilhaften Ausgestaltung erstreckt sich die Kante über zumindest zwei Transportspuren und weist zwischen diesen einen unstetigen Kantenverlauf auf. Unter einer Transportspur im Sinne der vorliegenden Erfindung ist eine Bewegungsbahn der Substrate zu verstehen, auf welcher die Substrate mittels der Transportvorrichtung durch den die Flüssigkeit enthaltenden Behälter transportierbar sind. Soweit in dieser Anmeldung von einem Transport der Substrate "durch" den die Flüssigkeit enthaltenden Behälter die Rede ist, ist der Begriff "durch" sehr weit zu verstehen. So hängt es von der konkreten Ausgestaltung der Transportvorrichtung ab, ob die Substrate im wörtlichen Sinne durch den Behälter transportiert werden oder eher über den Behälter hinweg. Beispielsweise werden die Substrate mittels Transportrollen zunächst über eine Behälterwandung hinweg transportiert, ehe sie in dem Behälter auf einer Höhe unterhalb einer Oberkante der Behälterwandung durch den Behälter transportiert und dabei deren Unterseiten mit der Flüssigkeit in Kontakt gebracht werden. In diesem Beispielsfall werden die Substrate in wörtlichem Sinne durch den Behälter transportiert. Insbesondere kann in diesem Behälter die Oberfläche der Flüssigkeit tiefer liegen als die Oberkante der Behälterwandung. In einer anderen Ausgestaltungsvariante kann die Oberfläche der Flüssigkeit in dem Behälter höher liegen als die Oberkante der Behälterwandung. Infolgedessen läuft Flüssigkeit über die Behälterwandung hinweg und wird beispielsweise in einem Überlaufbehälter aufgefangen und wieder dem Behälter zugeführt. Die Substrate brauchen in diesem Fall nicht bei dem Transport über die Behälterwandung hinweg angehoben zu werden, sondern können auf derselben Höhe wie außerhalb des Behälters über die Behälterwandung und den Behälter mit der Flüssigkeit darin transportiert werden und zwar derart, dass die Unterseiten der Substrate, während sie über den Behälter hinweg transportiert werden, mit der Flüssigkeit in Kontakt gebracht sind. Bei dieser Ausgestaltungsvariante würden manche Betrachter möglicherweise weniger von einem Transport der Substrate "durch" den Behälter, sondern stattdessen von einem Transport der Substrate über den Behälter hinweg sprechen. Im Sinne der vorliegenden Anmeldeung und der vorliegenden Erfindung werden jedoch auch diese Ausgestaltungsvariante und wirkungsgleiche Ausführungsformen von dem Begriff "durch" erfasst, sodass bei diesen ein Transport der Substrate durch den Behälter vorliegt.

Vorzugsweise sind die zumindest zwei Transportspuren parallel zueinander ausgerichtet, sodass mehrere Reihen von Substraten nebeneinanderliegend gleichzeitig durch den die Flüssigkeit enthaltenden Behälter transportierbar sind.

Unter einer Breite der Transportspur ist vorliegend eine maximale Breite der in dieser Transportspur transportierten Substrate zu verstehen. Diese Breite der transportierten Substrate erstreckt sich senkrecht zu der Transportrichtung. Zwischen zwei Transportspuren im Sinne der vorliegenden Erfindung befindet sich ein Bereich dann, wenn dieser nicht durch zumindest eine Transportspur abgedeckt ist. In der Praxis kann die Transportspur breiter gewählt werden, um Schwankungen in den Substratabmessungen oder Ungenauigkeiten bei einer Positionierung der Substrate auf der Transportvorrichtung Rechnung zu tragen.

Unter einem unstetigen Kantenverlauf im Sinne der vorliegenden Erfindung ist ein Kantenverlauf zu verstehen, welcher zumindest einen Sprung in Richtung der Transportrichtung oder in entgegengesetzter Richtung aufweist.

Vorteilhafterweise ist der unstetige Kantenverlauf derart ausgebildet, dass er zwischen zweien der zumindest zwei Transportspuren einen Sprung aufweist. Für den Fall, dass sich die Kante über mehr als zwei Transportspuren erstreckt, ist es vorteilhaft wenn der Kantenverlauf zwischen jeder der Transportspuren einen Sprung aufweist. Vorteilhafterweise bildet ein derartiger Kantenverlauf ein Sägezahnprofil aus.

Ein solch unstetiger Kantenverlauf ist leicht herstellbar, beispielsweise durch Fügen mehrerer jeweils gerade verlaufender und deshalb aufwandsgünstig herstellbarer Wehr- bzw. Kantenelemente.

Gemäß eine bevorzugten Weiterbildung erstreckt sich die Kante über zumindest zwei Transportspuren und weist zwischen diesen einen stetigen Kantenverlauf auf.

Stetig im Sinne der vorliegenden Erfindung ist ein Kantenverlauf dann, wenn er in der Transportrichtung und in entgegengesetzter Richtung keinen Sprung aufweist. Vorteilhafterweise verläuft der stetige Kantenverlauf in Form eines Dreiecksprofils über die Transportspuren, sodass zwischen den Transportspuren jeweils ein Knick angeordnet ist. Auf diese Weise kann im Vergleich zu einem Wehr mit einem unstetigen Kantenverlauf zwischen den Transportspuren ein verringerter Materialaufwand und somit eine aufwandsgünstigere Herstellung erreicht werden.

In einer vorteilhaften Ausführungsform weist die Kante einen in jedem Punkt in mathematischem Sinne differenzierbaren Kantenverlauf auf. Vorzugsweise kann der Kantenverlauf sinusförmig ausgebildet sein. Denkbar ist auch, dass der Kantenverlauf als eine beliebige Kurve oder gemäß einer Polynomfunktion ausgebildet ist. In der Praxis hat sich gezeigt, dass mit einem derartigen Kantenverlauf ein besonders sanfter Abriss der Flüssigkeitslamelle von den Substraten und folglich eine nochmalige Verminderung der Spritzer auf die Substratoberseite erreicht werden kann.

Um einen besonders hohen Schrägungswinkel der von den Substraten überfahrbaren Kante innerhalb einer Transportspur zu erreichen, ist es vorteilhaft, wenn die Kante innerhalb dieser Transportspur einen unstetigen Kantenverlauf aufweist. Durch den derart innerhalb der Transportspur maximierten Schrägungswinkel kann die Beanspruchung der Flüssigkeitslamelle an der Substrathinterkante weiter verringert, dadurch ein nochmals sanfterer Abriss erreicht und letztlich die Menge der ungewollt auf die Substratoberseite aufgespritzten Flüssigkeit weiter verringert werden.

In einer weiteren Ausgestaltung weist die Kante zumindest abschnittsweise einen gerundeten, vorzugsweise einen sinusförmigen Kantenverlauf auf. Durch eine entsprechende Anpassung des Rundungsverlaufs kann das Abrissverhalten des Flüssigkeitsfilms von den Substrathinterkanten unter Berücksichtigung der weiteren Prozessparameter, wie beispielsweise der Viskosität der Flüssigkeit oder dergleichen, vorteilhaft beeinflusst werden.

Hinsichtlich einer vereinfachten Montage des Wehres in der Vorrichtung kann es vorteilhaft sein, wenn sich die Kante über mehr als zwei Transportspuren, vorzugsweise über zumindest drei Transportspuren und besonders bevorzugt über alle Transportspuren, hinweg erstreckt. Derart kann zusätzlicher Montageaufwand für die Montage einzelner Wehre oder Kantenelemente je Transportspur vermieden werden.

Ein besonders aufwandsgünstiger und materialschonender Transport der Substrate kann erreicht werden, wenn die Vorrichtung in Transportrichtung vor und hinter dem Wehr angeordnete Transportrollen aufweist, mittels welchen die Substrate durch den die Flüssigkeit enthaltenden Behälter transportierbar sind.

In einer vorteilhaften Ausgestaltung erstreckt sich die Kante in Transportrichtung über mindestens 50 % eines lichten Abstands der in Transportrichtung betrachtet letzten vor dem Wehr angeordneten Transportrolle von der ersten nach dem Wehr angeordneten Transportrolle. In der Praxis hat sich gezeigt, dass derart bereits ein hinreichend großer Schrägungswinkel der Kanten und folglich eine wirksame Vermeidung von Spritzern auf der Substratoberseite erreicht werden kann. Um den Schrägungswinkel der Kante zur Transportrichtung zwischen zwei Transportrollen weiter zu erhöhen, ist es vorteilhaft, wenn sich die Kante in Transportrichtung über mindestens 75 % und besonders bevorzugt über mindestens 95 % des beschriebenen lichten Abstands erstreckt.

In einzelnen Anwendungsfällen kann es erforderlich sein, die Transportrollen in einem so geringen Abstand vor und hinter dem Wehr anzuordnen, dass bei einer Anordnung des Wehres zwischen den Transportrollen ein hinreichend schräger Kantenverlauf nicht mehr möglich ist. In solchen Fällen ist es vorteilhaft, wenn die Rotationsachse zumindest einer der Transportrollen das Wehr durchdringt. Derart kann erreicht werden, dass die Kante des Wehres trotz des geringen Abstands der Transportrollen hinreichend schräg ausgeführt werden kann, sodass Spritzer auf die Substratoberseite vermieden werden können.

Die erfindungsgemäße Vorrichtung kann vorteilhaft verwendet werden zur nasschemischen unterseitigen Behandlung von Substraten, vorzugsweise Solarzellenwafern, mit einer Flüssigkeit. Dabei werden die Substratunterseiten vorzugsweise mit der in einem Behälter angeordneten Flüssigkeit derart in Kontakt gebracht, dass sich zwischen der Flüssigkeitsoberfläche in dem Behälter und den Substraten ein Meniskus ausbildet.

Gegenstand der Erfindung ist außerdem ein Wehr zur Verwendung in einer Vorrichtung zur Behandlung von Substraten mit einer Flüssigkeit. Das erfindungsgemäße Wehr weist eine zumindest abschnittsweise schräg verlaufende Kante auf.

Im Wesentlichen senkrecht zu einer Haupterstreckungsrichtung des Wehres vorspringende Abschnitte der Kante werden vorliegend als Vorsprünge des Wehres beziehungsweise als Vorsprünge der Kante des Wehres bezeichnet. In analoger Weise werden in entgegengesetzter Richtung vorspringende Wehr- oder Kantenabschnitte vorliegend als Rücksprünge des Wehres beziehungsweise der Kante des Wehres bezeichnet. In einer vorteilhaften Weiterbildung weist die Kante zumindest einen Vorsprung oder zumindest einen Rücksprung auf, vorzugsweise einen Vorsprung.

In einer bevorzugten Ausführungsform weist die Kante zumindest abschnittsweise ein Sägezahnprofil auf. Dabei verlaufen die das Sägezahnprofil ausbildenden Vor- und/oder Rücksprünge der Kante im Wesentlichen senkrecht zu der Haupterstreckungsrichtung des Wehres.

In Abhängigkeit der spezifischen Prozessparameter, unter welchen das Wehr in der Vorrichtung eingesetzt werden soll, kann es zudem vorteilhaft sein, wenn die Kante zumindest abschnittsweise ein Dreiecksprofil und/oder ein Wellenprofil aufweist.

Im Hinblick auf ein gleichmäßiges Abfließen der Flüssigkeit von der Kante des Wehres ist es vorteilhaft, wenn die Kante ein, insbesondere gewelltes, Höhenprofil aufweist. Unter einem Höhenprofil ist vorliegend ein Verlauf der Kante des Wehres zu verstehen, welcher sich senkrecht zu dem zumindest abschnittsweise schrägen Kantenverlauf erstreckt.

Vorzugsweise ist das Wehr einstückig gefertigt, insbesondere mittels Materialabtrag, wie beispielsweise Fräsen, aus einem einstückigen Ausgangskörper. In der Praxis hat sich gezeigt, dass auf diese Weise eine verbesserte Maßhaltigkeit (Geradheit) der Wehrkanten gewährleistet werden kann. Zudem kann das Wehr in weniger Arbeitsschritten hergestellt werden. Dies gilt insbesondere im Vergleich zu einer alternativen Fertigungsmethode für das Wehr, bei welcher die Form der Kante durch Einklappen einer Kunststoffplatte und anschließendes Fixieren mittels Schweißnähten realisiert wird. Vorgenannte Vorteile ergeben sich auch im Vergleich zu einer Fertigung des Wehres aus einzelnen, nachträglich verbundenen Platten. Überdies hat sich in der Praxis gezeigt, dass bei der beschriebenen Herstellung des Wehres mittels Materialabtrag, insbesondere mittels Fräsen, aufwandsgünstig geeignete Befestigungselemente an der Unterseite des Wehres ausgebildet werden können. Diese Befestigungsmittel ermöglichen eine zuverlässige und einfache Befestigung des Wehres an der zugehörigen Vorrichtung.

In einer weiteren Ausführungsform weist das Wehr zumindest eine Öffnung zur Aufnahme einer Achse auf. Sofern die Vorrichtung, in welcher das Wehr verwendet werden soll, über Transportrollen zum Transport der Substrate verfügt, kann die Achse zumindest einer dieser Transportrollen in der zumindest einen Öffnung des Wehres aufgenommen sein. Vorteilhafterweise weist das Wehr ein in der zumindest einen Öffnung angeordnetes Dichtelement auf.

Im Übrigen ist die Erfindung gerichtet auf die Verwendung eines erfindungsgemäßen Wehres in einer erfindungsgemäßen Vorrichtung.

Das erfindungsgemäße Verfahren zum Ablösen einer Flüssigkeitslamelle von einer Substratkante sieht vor, an wenigstens einem Punkt der Flüssigkeit eine Abrissfront auszubilden. Diese Abrissfront wird entlang der Substratkante geführt und in dieser Weise eine Breite der Flüssigkeitslamelle (20) verringert. Unter der Breite der Flüssigkeitslammelle ist dabei deren Erstreckung im Wesentlichen parallel zu der Substratkante zu verstehen. Durch die Reduktion der Breite der Flüssigkeitslamelle vor deren Abreißen von der Substratkante kann, wie oben beschrieben, die Krafteinwirkung auf die Flüssigkeitslamelle vermindert und dieser Weise die Gefahr der Bildung von Spritzern reduziert werden.

Vorteilhafterweise wird die Breite der Flüssigkeitslamelle vor einem Abreißen der Flüssigkeitslamelle von der Substratkante um mindestens 50 %, vorzugsweise um mindestens 80 % und besonders bevorzugt um mindestens 97 % ihrer ursprünglichen Breite verringert. Auf diese Weise lässt die Gefahr der Spritzerbildung zunehmend verringern und im Bestfall vollständig vermeiden.

In einer bevorzugten Variante wird die Abrissfront an einer Ecke der Substratkante ausgebildet. Dies hat sich in der Praxis bewährt.

Vorteilhafterweise wird die Abrissfront bis zu einer Ecke der Substratkante geführt. Dies ermöglicht eine einfache und zuverlässige Verfahrensführung.

Im Weiteren wird die Erfindung anhand von Figuren näher erläutert. Soweit zweckdienlich, sind hierin gleichwirkende Elemente mit gleichen Bezugszeichen versehen. Die Erfindung ist nicht auf die in den Figuren dargestellten Ausführungsbeispiele beschränkt - auch nicht in Bezug auf funktionale Merkmale. Die bisherige Beschreibung wie auch die im nachfolgende Figurenbeschreibung enthalten zahlreiche Merkmale, die in den abhängigen Unteransprüchen teilweise zu mehreren zusammengefasst wiedergegeben sind. Diese Merkmale wie auch alle übrigen oben und in der nachfolgenden Figurenbeschreibung offenbarte Merkmale wird der Fachmann jedoch auch einzeln betrachten und zu sinnvollen weiteren Kombinationen zusammenfügen. Insbesondere sind diese Merkmale jeweils einzeln und in beliebiger geeigneter Kombination mit der Vorrichtung sowie dem Wehr des jeweiligen unabhängigen Anspruchs kombinierbar.

Es zeigen:
- Figur 1: schematische Darstellungen einer ausschnittsweisen Seitenansicht einer Vorrichtung gemäß dem Stand der Technik in einem ersten (a), einem zweiten (b) und einem dritten(c) Zustand,
- Figur 2: eine Prinzipdarstellung zur Verdeutlichung der Ausbildung einer Flüssigkeitslamelle zwischen einer Substrathinterkante und einem Wehr mit einer gerade verlaufenden Kante gemäß dem Stand der Technik,
- Figur 3: eine erstes Ausführungsbeispiel einer Vorrichtung sowie eines Wehres mit einer zumindest abschnittsweise schräg verlaufenden Kante in einer schematischen Darstellung,
- Figur 4: eine Prinzipdarstellung zur Verdeutlichung der Ausbildung eines Flüssigkeitsfilms bei zumindest abschnittsweise schräg verlaufender Kante in einem ersten (a) und einem zweiten (b) Zustand sowie ein Ausführungsbeispiel des erfindungsgemäßen Verfahrens,
- Figur 5: eine schematische Darstellung einer Weiterbildung der Vorrichtung gemäß Figur 3,
- Figur 6: eine schematische Darstellung eines weiteren Ausführungsform der Vorrichtung gemäß Figur 3,
- Figur 7: eine schematische Darstellung einer weiteren Ausgestaltung der Vorrichtung gemäß Figur 3,
- Figur 8: eine schematische Darstellung einer Weiterbildung der Vorrichtung gemäß Figur 3,

- Figur 9: eine ausschnittsweise Seitenansicht der Darstellung gemäß Figur 8
- Figur 10: eine schematische Darstellung einer perspektivischen Ansicht eines Wehres.

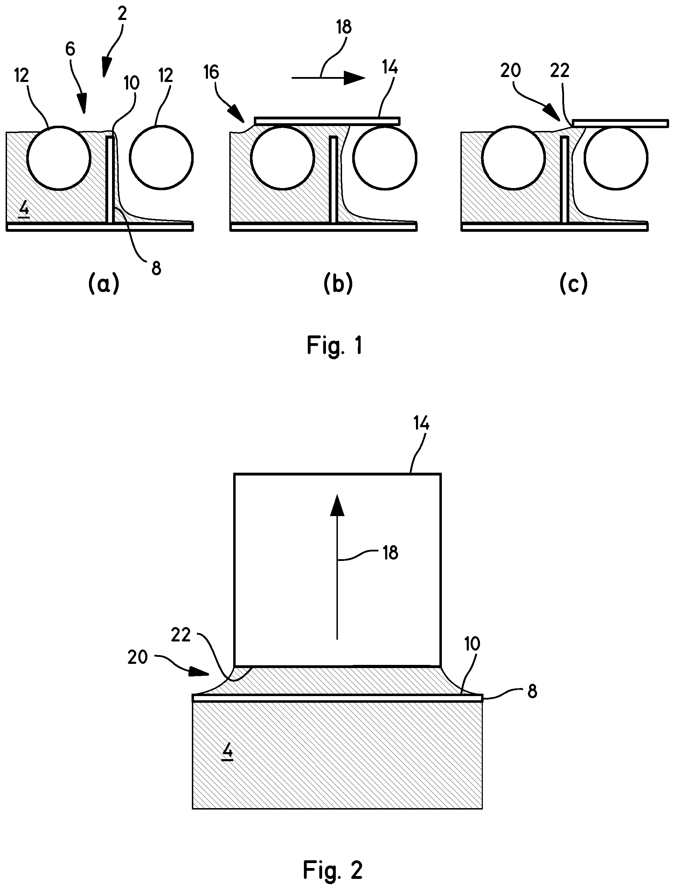

Figur 1 zeigt eine Vorrichtung 2 zur Behandlung von Substraten mit einer Flüssigkeit 4 gemäß dem Stand der Technik in einem ersten (a), einem zweiten (b) und einem dritten (c) Zustand. Die Vorrichtung 2 ist in einer Schnittdarstellung und aus zeichnerischen Gründen lediglich teilweise, d.h. unter Auslassung weiterer Elemente der Vorrichtung 2, dargestellt. Die Vorrichtung 2 weist einen die Flüssigkeit 4 enthaltenden Behälter 6 auf, welcher einseitig mittels eines Wehres 8 begrenzt ist. Das Wehr 8 ist dazu ausgebildet einen Austritt der Flüssigkeit 4 aus dem Behälter 6 zu verhindern beziehungsweise zu begrenzen. Zudem weist das Wehr 8 eine von Substraten 14 überfahrbare gerade Kante 10 auf. Beiderseits des Wehres 8 sind Transportrollen 12 angeordnet, mittels welchen Substrate über die Flüssigkeit 4 beziehungsweise über die Kante 10 des Wehres 8 transportierbar sind.

Ein solcher Transportzustand ist in Figur 1(b) schematisch dargestellt. Diese zeigt, wie das Substrat 14 unter Ausbildung eines unterseitigen Flüssigkeitsfilms 16 mittels der Transportrollen 12 über das Wehr 8 und dessen Kante 10 längs einer Transportrichtung 18 transportiert wird. Wie in Figur 1(c) erkennbar ist, bildet sich bei einem Weitertransport des Substrats 14 bedingt durch die Oberflächenspannung der Flüssigkeit 4 eine Flüssigkeitslamelle 20 an der Hinterkante 22 des Substrats 14 aus. Diese reißt bei einem Überfahren der geraden Kante 10 nicht unmittelbar ab, sondern wird gedehnt.

Figur 2 zeigt eine Prinzipdarstellung zur Verdeutlichung der Ausbildung dieser Flüssigkeitslamelle 20 zwischen der Substrathinterkante 22 und dem Wehr 8, beziehungsweise der geraden Kante 10. Dabei entspricht die Ansicht der Figur 2 einer Draufsicht des in Figur 1(c) dargestellten Zustands, wobei einige Elemente der Vorrichtung 24 der besseren Übersichtlichkeit wegen nicht dargestellt sind. Bei einem Weitertransport des Substrats 14 längs der Transportrichtung 18 erfolgt eine weitere Dehnung der Flüssigkeitslamelle 20, bis deren Beanspruchungsgrenze überschritten wird und es folglich zu einem Abriss der Flüssigkeitslamelle 20 von der Substrathinterkante 22 kommt. Durch den geraden Verlauf der Kante 10 des Wehres 8 zur Transportrichtung 18 stellt sich eine im Wesentlichen homogene Dehnung der Flüssigkeitslamelle 20 längs der Transportrichtung 18 ein. Vereinfacht ausgedrückt existiert längs der Flüssigkeitslamelle 20 keine Stelle, welche eine ausgeprägte Spannungsüberhöhung aufweist. Der Abriss der Flüssigkeitslamelle 20 erfolgt demnach ausgehend von einer geometrisch nicht eindeutig festgelegten Stelle. Bei einem derart undefinierten Abriss der Flüssigkeitslamelle 20 kommt es häufig zu einer Spritzerbildung, bei welcher Flüssigkeit 4 in ungewollter Weise auf die Oberseite des Substrats 14 oder im Prozess nachfolgender Substrate geschleudert wird.

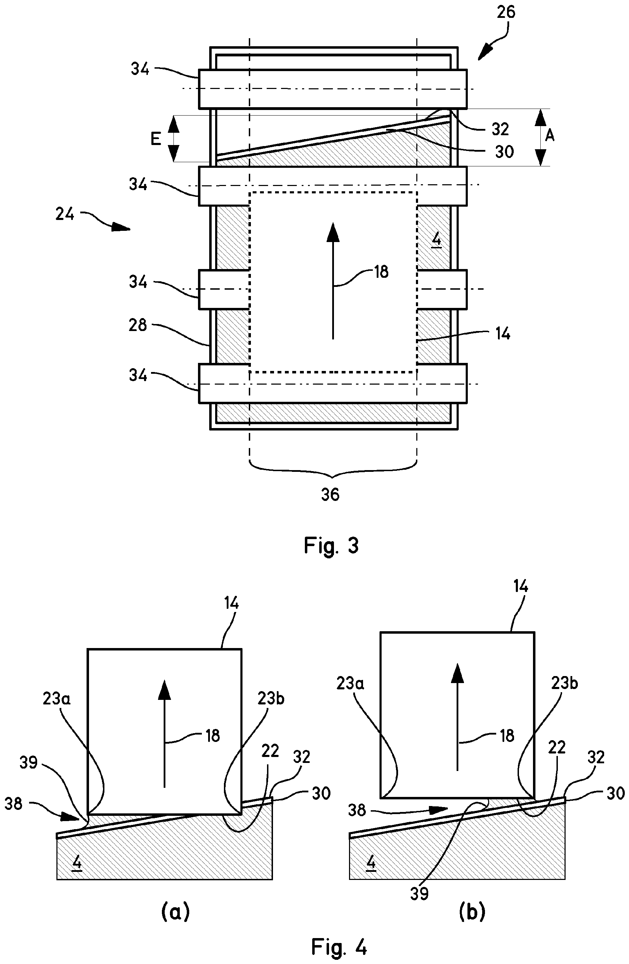

Figur 3 zeigt eine schematische Darstellung einer Vorrichtung 24 zur Behandlung von Substraten 14 mit einer Flüssigkeit 4. Die Vorrichtung 24 weist eine Transportvorrichtung 26 auf, mittels welcher die Substrate 14 durch einen die Flüssigkeit 4 enthaltenden Behälter 28 transportierbar sind. Außerdem weist die Vorrichtung 24 ein Wehr 30 mit einer von den Substraten 14 überfahrbaren Kante 32 auf, welche zumindest abschnittsweise schräg zu der Transportrichtung 18 der Substrate 14 verläuft.

Die Transportvorrichtung 26 weist in Transportrichtung 18 vor und hinter dem Wehr 30 angeordnete Transportrollen 34 auf, mittels welchen die Substrate, beziehungsweise das Substrat 14, durch den die Flüssigkeit 4 enthaltenden Behälter 28 transportierbar sind.

Im vorliegenden Ausführungsbeispiel beträgt die maximale Erstreckung E der Kante 32 in Transportrichtung 18 zumindest 95 Prozent des Abstands A der Transportrollen 34, welche unmittelbar vor und hinter dem Wehr 30 in Transportrichtung 18 angeordnet sind.

In Figur 3 ist das Substrat gestrichelt dargestellt, da dieses nicht Bestandteil der Vorrichtung 24 ist. Durch die im vorliegenden Fall dargestellte Auflage des einzelnen Substrats 14 auf den Transportrollen 34 wird längs der Transportrichtung 18 eine einzelne Transportspur 36 ausgebildet, entlang welcher sich das Substrat 14 durch den die Flüssigkeit 4 enthaltenden Behälter 28 bewegt. Die Darstellung der Figur 3 beschränkt sich auf lediglich eine Transportspur 36, wobei durch die Auflage mehrerer beispielsweise kleinerer und/oder schmalerer Substrate 14 und/oder die Verwendung breiterer Transportrollen weitere Transportspuren 36 ausgebildet sein können. Grundsätzlich kann die Vorrichtung 24 auch mehrere nebeneinander angeordnete Transportvorrichtungen 26 beziehungsweise Transportrollen 34 aufweisen, sodass längs einer jeder der nebeneinander liegenden Reihen von Transportrollen eine Transportspur 36 ausgebildet sein kann.

Figur 4 zeigt eine Prinzipdarstellung zur Verdeutlichung des Abrisses einer Flüssigkeitslamelle 38 von der Substrathinterkante 22 beim Überfahren der schräg zu der Transportrichtung 18 verlaufenden Kante 32 des Wehres 30 in einem ersten (a) und einem zweiten (b) Zustand. Auf diese Weise illustriert Figur 4 gleichzeitig ein Ausführungsbeispiel des erfindungsgemäßen Verfahrens. Wie bereits im Zusammenhang mit der Prinzipdarstellung in Figur 2 verdeutlicht, wird die Flüssigkeitslamelle 38 beim Überfahren der Kante 32 zunächst längs der Transportrichtung 18 gedehnt und mechanisch beansprucht. Da die Kante 32 des Wehres 30 schräg zur Transportrichtung 18 verläuft, erfährt die Flüssigkeitslamelle 38 an einer unteren linken Ecke 23a des Substrats 14, beziehungsweise an der Ecke 23a der Substratkante 22, zunächst die höchste mechanische Beanspruchung. Wie Figur 2 (b) illustriert, wird an dieser Stelle eine Abrissfront 39 ausgebildet und es beginnt ausgehend von dieser Stelle ein Rückzug der Flüssigkeitslamelle 38 in Richtung der rechten unteren Ecke 23b des Substrats 14. Die Abrissfront 39 wird entlang der Substratkante 22 geführt und in dieser Weise eine Breite der Flüssigkeitslamelle 38 verringert. Infolge des schrägen Verlaufs der Kante 32 wird die Abrissfront 39 bis zu der Ecke 23b der Substratkante 22 geführt und dort ein gezielter Abriss der Flüssigkeitslamelle 38 erreicht, bei welchem die Bildung von Spritzern und das ungewollte Aufbringen von Flüssigkeit 4 auf die Oberseite des Substrats 14 vermieden werden kann.

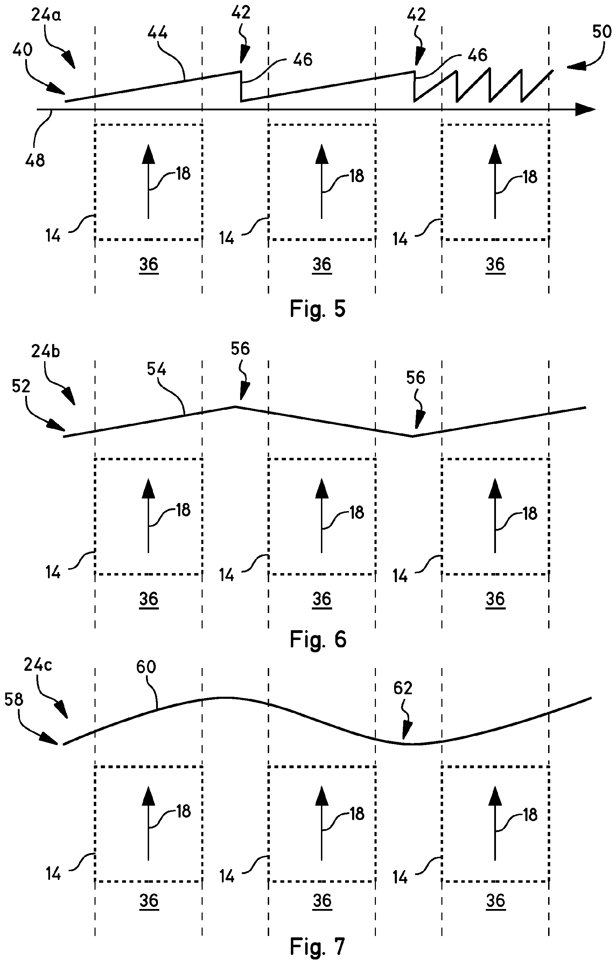

Figur 5 zeigt eine weitere Vorrichtung 24a, bei welcher drei parallel zueinander und längs der Transportrichtung 18 für die Substrate 14 verlaufende Transportspuren 36 ausgebildet sind. Im Übrigen unterscheidet sich die Vorrichtung 24a im Wesentlichen hinsichtlich der Gestaltung des Wehres und dessen Kante von der Vorrichtung 24, so dass die weiteren Elemente der Vorrichtung 24a in Figur 5 nicht dargestellt sind.

Das im Ausführungsbeispiel der Figur 5 verwendete Wehr 40 weist eine Kante 44 auf, die sich über zumindest zwei der Transportspuren 36 erstreckt und zwischen diesen einen unstetigen Kantenverlauf 42 aufweist. Der Kantenverlauf 42 weist längs der Transportrichtung 18 mehrere Vorsprünge 46 auf. Grundsätzlich können diese alternativ auch als Rücksprünge ausgeführt werden. Die Vorsprünge 46 erstrecken sich im Wesentlichen in eine Richtung, welche senkrecht zu einer Haupterstreckungsrichtung 48 des Wehres verläuft. Demgemäß weist die Kante 44 ein Sägezahnprofil 50 auf. Um den Schrägungswinkel innerhalb einer Transportspur weiter zu maximieren, weist die Kante 44 innerhalb der rechten Transportspur 36 einen unstetigen Kantenverlauf mit mehreren Vorsprüngen 46.

Figur 6 zeigt eine weitere Vorrichtung 24b mit einem Wehr 52, welches eine Kante 54 aufweist. Die Kante 54 erstreckt sich über drei Transportspuren 36 und weist zwischen diesen einen stetigen Kantenverlauf 56 auf. Betreffend die zeichnerische Darstellung weiterer Elemente der Vorrichtung 24b gelten die Ausführungen zu Figur 5 in analoger Weise.

Eine weitere Vorrichtung 24c ist in Figur 7 dargestellt. Diese weist ein Wehr 58 mit einer Kante 60 auf, welche sich wiederum über drei Transportspuren 36 erstreckt. Vorliegend weist die Kante 60 einen in jedem Punkt differenzierbaren Kantenverlauf 62 auf. Der Kantenverlauf 62 weist weder Sprünge noch Knicke auf. Die Kante 60 ist gerundet und weist vorliegend einen sinusförmigen Kantenverlauf auf. Betreffend die zeichnerische Darstellung weiterer Elemente der Vorrichtung 24c gelten die Ausführungen zu Figur 5 in analoger Weise.

Je nach Anwendungsfall ist es auch möglich, dass ein und dieselbe Kante eine abschnittsweise Kombination der in den Ausführungsbeispielen gemäß der Figuren 5, 6 und 7 enthaltenen Kantenverläufe 42, 56 und 62 aufweist. In anderen Worten: ein und dasselbe Wehr kann eine Kante mit einem abschnittsweise stetigen, unstetigen und/oder differenzierbaren Kantenverlauf aufweisen.

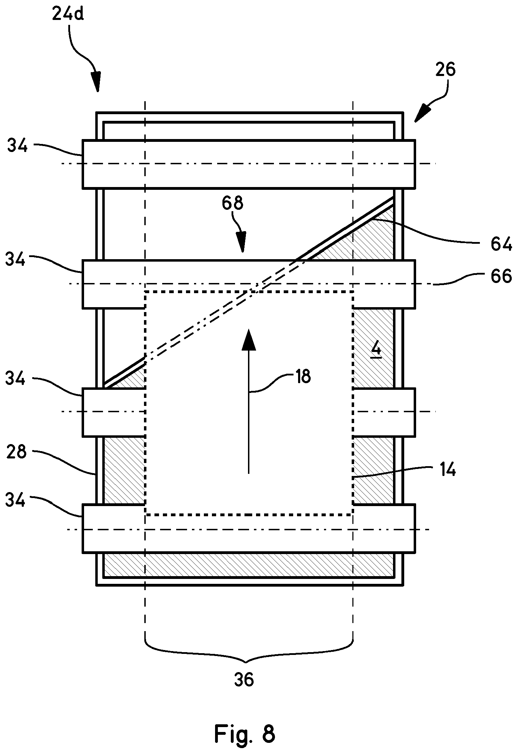

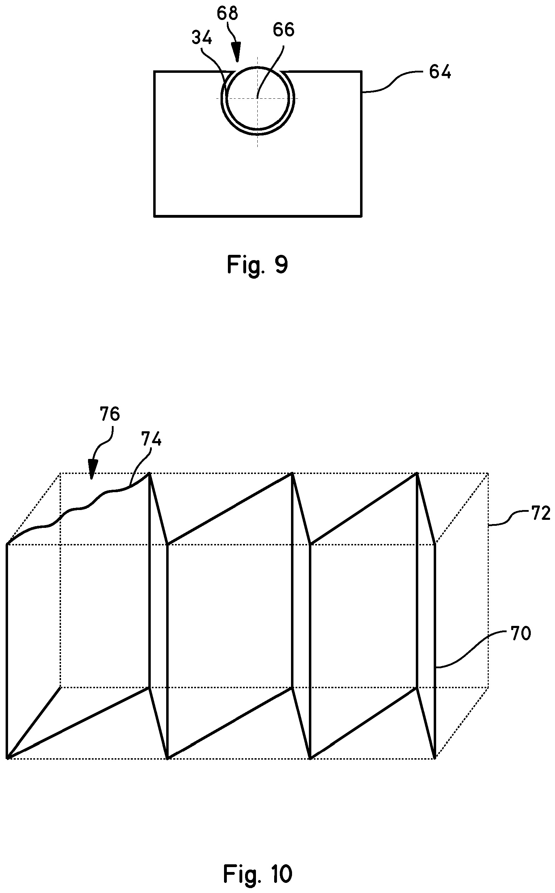

Figur 8 zeigt eine schematische Darstellung einer weiteren Vorrichtung 24d. Die Vorrichtung 24d weist ein Wehr 64 auf, welches von einer Rotationsachse 66 einer der Transportrollen 34 durchdrungen ist. Zu diesem Zweck weist das Wehr 64 eine Öffnung 68 zur Aufnahme der Achse 66 auf. Figur 9 zeigt eine ausschnittsweise Seitenansicht der Darstellung der Figur 8 und verdeutlich die Anordnung der Öffnung 68 zur Aufnahme der Achse 66 der Transportrolle 34.

Figur 10 zeigt eine schematische Darstellung einer perspektivischen Ansicht eines Wehres 70 zur Verwendung in einer Vorrichtung gemäß einem der vorangegangenen Ausführungsbeispiele. Vorliegend ist das Wehr 70 mittels Materialabtrag, genauer mittels Fräsen von einem Ausgangskörper 72, welcher gestrichelt dargestellt ist, gefertigt. Das Wehr 70 weist eine Kante 74 auf, welche abschnittsweise ein gewelltes Höhenprofil 76 aufweist. Vorzugsweise kann das Höhenprofil 76 längs der gesamten Kante 74 des Wehres 70 ausgebildet sein, wobei vorliegend aus Gründen der besseren Darstellbarkeit lediglich ein abschnittsweiser Verlauf des Höhenprofils illustriert ist.

### Bezugszeichenliste

- 2: Vorrichtung gemäß dem Stand der Technik
- 4: Flüssigkeit
- 6: Behälter
- 8: Wehr
- 10: gerade Kante
- 12: Transportrollen
- 14: Substrat
- 16: Flüssigkeitsfilm
- 18: Transportrichtung
- 20: Flüssigkeitslamelle
- 22: Substrathinterkante
- 23a, 23b: Ecke
- 24, 24a-d: Vorrichtung
- 26: Transportvorrichtung
- 28: Behälter
- 30: Wehr
- 32: schräge Kante
- 34: Transportrollen
- 36: Transportspur
- 38: Flüssigkeitslamelle
- 39: Abrissfront
- 40: Wehr
- 42: unstetiger Kantenverlauf
- 44: unstetige Kante
- 46: Vorsprung
- 48: Haupterstreckungsrichtung
- 50: Sägezahnprofil
- 52: Wehr
- 54: stetige Kante
- 56: stetiger Kantenverlauf
- 58: Wehr
- 60: Kante
- 62: Kantenverlauf
- 64: Wehr
- 66: Rotationsachse
- 68: Öffnung
- 70: Wehr
- 72: Ausgangskörper
- 74: Kante
- 76: Höhenprofil
- A: Abstand
- E: Erstreckung

## Patentansprüche

1. Vorrichtung (24, 24a-d) zur Behandlung von Substraten (14) mit einer Flüssigkeit (4) aufweisend eine Transportvorrichtung (26), mittels welcher die Substrate (14) in einer Transportrichtung (18) durch einen die Flüssigkeit (4) enthaltenden Behälter (28) transportierbar sind; und
**gekennzeichnet durch**
ein Wehr (30, 40, 52, 58, 64, 70) mit einer von den Substraten (14) überfahrbaren Kante (32, 44, 54, 60, 74), welche zumindest abschnittsweise schräg zu der Transportrichtung (18) der Substrate (14) verläuft.

2. Vorrichtung (24a) nach Anspruch 1,
**dadurch gekennzeichnet,**
**dass** die Kante (44) sich über zumindest zwei Transportspuren (36) erstreckt und zwischen diesen einen unstetigen Kantenverlauf (42) aufweist.

3. Vorrichtung (24b) nach einem der vorgenannten Ansprüche,
**dadurch gekennzeichnet,**
**dass** die Kante (54) sich über zumindest zwei Transportspuren (36) erstreckt und zwischen diesen einen stetigen Kantenverlauf (56) aufweist.

4. Vorrichtung (24a) nach einem der vorgenannten Ansprüche,
**dadurch gekennzeichnet,**
**dass** die Kante (44) innerhalb zumindest einer Transportspur (36) einen unstetigen Kantenverlauf (42) aufweist.

5. Vorrichtung (24a-c) nach einem der vorgenannten Ansprüche,
**dadurch gekennzeichnet,**
**dass** die Kante (44, 54, 60) sich über mehr als zwei Transportspuren (36), vorzugsweise über zumindest drei Transportspuren (36) und besonders bevorzugt über alle Transportspuren (36) hinweg erstreckt.

6. Vorrichtung (24, 24a-d) nach einem der vorgenannten Ansprüche,
**gekennzeichnet durch**
in Transportrichtung (18) vor und hinter dem Wehr (30, 40, 52, 58, 64, 70) angeordnete Transportrollen (34), mittels welchen die Substrate (14) durch den die Flüssigkeit (4) enthaltenden Behälter (28) transportierbar sind.

7. Vorrichtung (24, 24a-d) nach Anspruch 6,
**dadurch gekennzeichnet,**
**dass** sich die Kante (32, 44, 54, 60, 74) über mindestens 50 %, vorzugsweise über mindestens 75 % und besonders bevorzugt über mindestens 95 %, eines lichten Abstands (A) einer in Transportrichtung (18) betrachtet letzten vor dem Wehr (30, 40, 52, 58, 64, 70) angeordneten Transportrolle (34) von einer ersten in Transportrichtung (18) betrachtet nach dem Wehr (30, 40, 52, 58, 64, 70) angeordneten Transportrolle (34) erstreckt.

8. Vorrichtung (24d) nach einem der Ansprüche 6 bis 7,
**dadurch gekennzeichnet,**
**dass** die Rotationsachse (66) zumindest einer der Transportrollen (34) das Wehr (64) durchdringt.

9. Wehr (30, 40, 52, 58, 64, 70) zur Verwendung in einer Vorrichtung (24, 24a-d) zur Behandlung von Substraten (14) mit einer Flüssigkeit (4) nach einem der Ansprüche 1 bis 8,
**gekennzeichnet durch**
eine zumindest abschnittsweise schräg verlaufende Kante (32, 44, 54, 60, 74) .

10. Wehr (40, 52, 58, 70) nach Anspruch 9,
**dadurch gekennzeichnet,**
**dass** die Kante (44, 54, 60, 74) zumindest einen Vorsprung (46) oder zumindest einen Rücksprung aufweist, vorzugsweise einen Vorsprung (46).

11. Wehr (40, 70) nach einem der Ansprüche 9 oder 10,
**dadurch gekennzeichnet, dass**
- die Kante (44, 74) zumindest abschnittsweise ein Sägezahnprofil (50) aufweist;
- die Kante (74) ein unebenes, vorzugsweise gewelltes, Höhenprofil aufweist (76).

12. Verwendung eines Wehrs (30, 40, 52, 58, 64, 70) nach einem der Ansprüche 9 bis 11 in einer Vorrichtung (24, 24a-d) nach einem der Ansprüche 1 bis 8.

13. Verfahren zum Ablösen einer Flüssigkeitslamelle (38) von einer Substratkante (22), bei welchem an wenigstens einem Punkt der Flüssigkeitslamelle (38) eine Abrissfront (39) ausgebildet wird, welche entlang der Substratkante (22) geführt und in dieser Weise eine Breite der Flüssigkeitslamelle (38) verringert wird.

14. Verfahren nach Anspruch 13,
**dadurch gekennzeichnet,**
**dass** die Breite der Flüssigkeitslamelle (38) vor einem Abreißen der Flüssigkeitslamelle (38) von der Substratkante (22) um mindestens 50 %, vorzugsweise um mindestens 80 % und besonders bevorzugt um mindestens 97 % ihrer ursprünglichen Breite verringert wird.

15. Verfahren nach einem der Ansprüche 13 bis 14,
**dadurch gekennzeichnet, dass**
- die Abrissfront (39) an einer Ecke (23a) der Substratkante (22) ausgebildet wird;
- die Abrissfront bis zu einer Ecke der Substratkante (22) geführt wird.

## Claims

1. Device (24, 24a-d) for treating substrates (14) with a liquid (4) that has a transportation device (26), by means of which the substrates (14) are transportable in a transportation direction (18) through a container (28) that contains the liquid (4); and
**characterized by**
a weir (30, 40, 52, 58, 64, 70) having an edge (32, 44, 54, 60, 74) that is navigable by the substrates (14) and at least in portions runs obliquely to the transportation direction (18) of the substrates (14).

2. Device (24a) according to claim 1,
**characterized in that**
the edge (44) extends across at least two transportation tracks (36) and therebetween has a discontinuous edge profile (42).

3. Device (24b) according to one of the preceding claims,
**characterized in that**
the edge (54) extends across at least two transportation tracks (36) and has therebetween a continuous edge profile (56) .

4. Device (24a) according to one of the preceding claims,
**characterized in that**
the edge (44) within at least one transportation track (36) has a discontinuous edge profile (42).

5. Device (24a-c) according to one of the preceding claims,
**characterized in that**
the edge (44, 54, 60) extends across more than two transportation tracks (36), preferably across at least three transportation tracks (36), and particularly preferably across all transportation tracks (36).

6. Device (24, 24a-d) according to one of the preceding claims,
**characterized by**
transportation rollers (34) that in the transportation direction (18) are disposed ahead of and behind the weir (30, 40, 52, 58, 64, 70) and by means of which the substrates (14) are transportable through the container (28) that contains the liquid (4).

7. Device (24, 24a-d) according to claim 6,
**characterized in that**
the edge (32, 44, 54, 60, 74) extends across at least 50%, preferably across at least 75%, and particularly preferably across at least 95% of an available spacing (A) of a transportation roller (34) that when viewed in a transportation direction (18) is disposed as the last one ahead of the weir (30, 40, 52, 58, 64, 70) from a transportation roller (34) that when viewed in a transportation direction (18) is disposed as the first one behind the weir (30, 40, 52, 58, 64, 70) .

8. Device (24d) according to claims 6 to 7,
**characterized in that**
the rotation axis (66) of at least one of the transportation rollers (34) penetrates the weir (64).

9. Weir (30, 40, 52, 58, 64, 70) for the use in a device (24, 24a-d) for treating substrates (14) with a liquid (4) according to one of the claims 1 to 8,
**characterized by**
an edge (32, 44, 54, 60, 74) that runs obliquely at least in portions.

10. Weir (40, 52, 58, 70) according to claim 9,
**characterized in that**
the edge (44, 54, 60, 74) has at least one protrusion (46) or at least one recess, preferably a protrusion (46).

11. Weir (40, 70) according to one of the claims 9 or 10,
**characterized in that**
- the edge (44, 74) at least in portions has a sawtooth profile (50);
- the edge (74) has a non-planar, preferably an undulated, vertical profile (76).

12. Use of a weir (30, 40, 52, 58, 64, 70) according to one of the claims 9 to 11 in a device (24, 24a-d) according to one of the claims 1 to 8.

13. Method for detaching a liquid lamella (38) from a substrate edge (22), in which method a tear-off front (39) is formed at at least one point of the liquid lamella (38), said tear-off front (39) being guided along the substrate edge (22) and a width of the liquid lamella (38) being reduced in this way.

14. Method according to claim 13, ,
**characterized in that**
the width of the liquid lamella (38) is reduced by at least 50%, preferably by at least 80%, and particularly preferably by least 97% of its original width, prior to being torn off the substrate edge (22).

15. Method according to one of claims 13 to 14, ,
**characterized in that**
- the tear-off front (39) is formed at a corner (23a) of the substrate edge (22);
- the tear-off front is guided up to a corner of the substrate edge (22).

## Revendications

1. Dispositif (24, 24a-d) pour le traitement de substrats (14) avec un liquide (4) qui présente un dispositif de transport (26) au moyen duquel les substrats (14) peuvent être transportés dans un sens de transport (18) par un conteneur (28) qui contient le liquide (4) et
**caractérisé par** un déversoir (30, 40, 52, 58, 64, 70) avec une arête (32, 44, 54, 60, 74) praticable par les substrats (14) qui s'étend en étant inclinée au moins par tronçons par rapport au sens de transport (18) des substrats (14).

2. Dispositif (24a) selon la revendication 1, **caractérisé en ce que** l'arête (44) s'étend sur au moins deux voies de transport (36) et présente un tracé discontinu (42) entre celles-ci.

3. Dispositif (24b) selon l'une des revendications précédentes, **caractérisé en ce que** l'arête (54) s'étend sur au moins deux voies de transport (36) et présente un tracé continu (56) entre celles-ci.

4. Dispositif (24a) selon l'une des revendications précédentes, **caractérisé en ce que** l'arête (44) présente un tracé discontinu (42) à l'intérieur d'au moins une voie de transport (36).

5. Dispositif (24a-c) selon l'une des revendications précédentes, **caractérisé en ce que** l'arête (44, 54, 60) s'étend sur plus de deux voies de transport (36), de préférence sur au moins trois voies de transport (36) et de manière particulièrement préférée au-delà de toutes les voies de transport (36).

6. Dispositif (24, 24a-d) selon l'une des revendications précédentes, **caractérisé par** des galets de transport (34), placés devant et derrière le déversoir (30, 40, 52, 58, 64, 70) dans le sens de transport (18), au moyen desquels les substrats (14) peuvent être transportés par le conteneur (28) qui contient le liquide (4).

7. Dispositif (24, 24a-d) selon la revendication 6, **caractérisé en ce que** l'arête (32, 44, 54, 60, 74) s'étend sur au moins 50%, de préférence sur au moins 75% et de manière particulièrement préférée sur au moins 95%, d'une distance libre (A) entre un dernier galet de transport (34) placé devant le déversoir (30, 40, 52, 58, 64, 70), ceci étant considéré dans le sens du transport (18), et un premier galet de transport (34) placé après le déversoir (30, 40, 52, 58, 64, 70), ceci étant considéré dans le sens du transport (18).

8. Dispositif (24d) selon l'une des revendications 6 à 7, **caractérisé en ce que** l'axe de rotation (66) d'au moins l'un des galets de transport (34) traverse le déversoir (64).

9. Déversoir (30, 40, 52, 58, 64, 70) pour l'utilisation dans un dispositif (24, 24a-d) pour le traitement de substrats (14) avec un liquide (4) selon l'une des revendications 1 à 8, **caractérisé par** au moins une arête (32, 44, 54, 60, 74) qui s'étend en étant inclinée au moins par tronçons.

10. Déversoir (40, 52, 58, 70) selon la revendication 9, **caractérisé en ce que** l'arête (44, 54, 60, 74) présente au moins une saillie (46) ou au moins un retrait, de préférence une saillie (46).

11. Déversoir (40, 70) selon l'une des revendications 9 ou 10, **caractérisé en ce que**
- l'arête (44, 74) présente un profil en dents de scie (50) au moins par tronçons ;
- l'arête (74) présente un profil inégal en hauteur (76), de préférence ondulé.

12. Utilisation d'un déversoir (30, 40, 52, 58, 64, 70) selon l'une des revendications 9 à 11 dans un dispositif (24, 24a-d) selon l'une des revendications 1 à 8.

13. Procédé pour détacher une lamelle de liquide (38) d'une arête de substrat (22) dans lequel un front de déchirure (39) est formé en au moins un point de la lamelle de liquide (38), front qui passe le long de l'arête de substrat (22) et de cette manière une largeur de la lamelle de liquide (38) est diminuée.

14. Procédé selon la revendication 13, **caractérisé en ce que** la largeur de la lamelle de liquide (38) est diminuée, avant un déchirement de la lamelle de liquide (38) de l'arête du substrat (22), d'au moins 50%, de préférence d'au moins 80% et de manière particulièrement préférée d'au moins 97% de sa largeur initiale.

15. Procédé selon l'une des revendications 13 à 14, **caractérisé en ce que**
- le front de déchirure (39) est formé à un coin (23a) de l'arête de substrat (22) ;
- le front de déchirure s'étend jusqu'à un coin de l'arête de substrat (22).
